Europäisches Patentamt

**European Patent Office**

Office européen des brevets

(19)

(11) Numéro de publication: **0 148 065**
**A2**

(12) # DEMANDE DE BREVET EUROPEEN

(21) Numéro de dépôt: 84402558.5

(22) Date de dépôt: 12.12.84

(51) Int. Cl.⁴: **H 01 L 29/90**
**H 01 L 29/08**

(30) Priorité: 14.12.83 FR 8320032

(43) Date de publication de la demande:
10.07.85 Bulletin 85/28

(84) Etats contractants désignés:
DE FR GB IT NL

(71) Demandeur: FAIRCHILD CAMERA & INSTRUMENT
CORPORATION
464 Ellis Street
Mountain View California 94042(US)

(72) Inventeur: Rossetti, Pierre
12, Chemin Renaudin
92260 Fontenay aux Roses(FR)

(72) Inventeur: Arnould, Jacques
T 1003 Celony
13090 Aix en Provence(FR)

(74) Mandataire: Chareyron, Lucien et al,
Schlumberger Limited Service Brevets c/o Giers 12, place
des Etats Unis B.P. 121
F-92124 Montrouge Cédex(FR)

(54) Composant semiconducteur rapide, notamment diode pin haute tension.

(57) L'invention concerne un composant semiconducteur haute tension rapide, notamment une diode, comprenant une zone interne, formée d'au moins une couche de silicium à haute résistivité, comprise entre deux couches extérieures supérieure et inférieure de silicium extrinsèque.

Selon l'invention, l'une et l'autre des couches extérieures inférieure et supérieure sont, au moins dans une région active (11), du composant, des couches minces (P, N) et la couche de silicium à haute résistivité (I) est dépourvue de centres de recombinaison supplémentaires susceptibles de réduire la durée de vie des porteurs minoritaires présents dans cette couche au moment de la transition de l'état passant à l'état bloqué, l'épaisseur et le dopage des couches extérieures (P, N) étant déterminés en fonction du degré d'injection souhaité desdits porteurs minoritaires dans la phase de conduction.

FIG_11

EP 0 148 065 A2

NOTAMMENT DIODE PIN HAUTE TENSION

La présente invention concerne un composant semiconducteur haute tension rapide, formé d'une zone interne, comprenant au moins une couche de silicium à haute résistivité, comprise entre deux couches extérieures supérieure et inférieure de silicium extrinsèque.

On se réfèrera principalement au cours de la présente description au cas de la diode PIN, qui correspond à une structure dans laquelle la zone interne est formée d'une couche unique de silicium à haute résistivité, les couches extérieures étant l'une du type N, l'autre du type P. Il ne s'agit cependant là que d'une application particulière, et on verra par la suite que les enseignements de l'invention peuvent être appliqués à d'autres types de semiconducteurs à jonction, notamment des redresseurs contrôlés et des transistors.

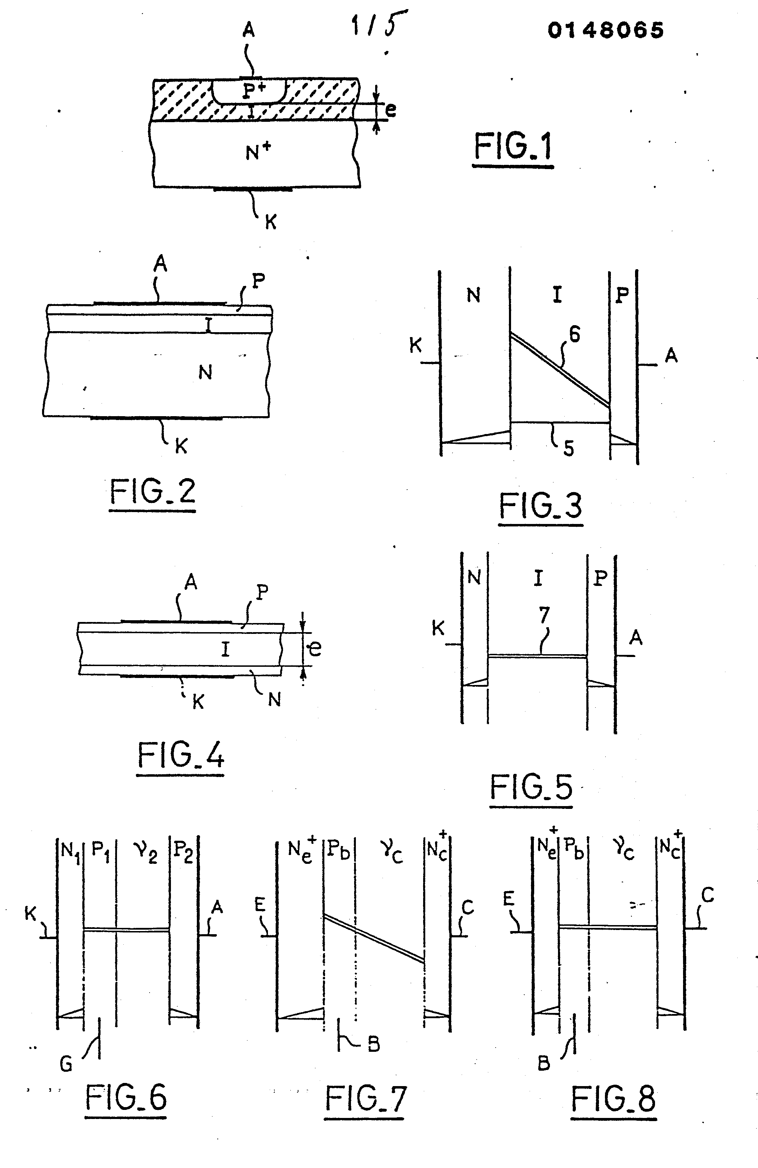

Jusqu'à présent, les diodes PIN avaient la plupart du temps la structure indiquée figure 1, à savoir une couche I de silicium à haute résistivité, comprise entre deux couches P et N formant respectivement l'anode et la cathode de la diode. L'épaisseur de la couche I est déterminée en fonction de la tension inverse que doit supporter la diode, par exemple sur la base d'un gradient de tension d'environ 20 V/μm, et les couches P et N sont des couches fortement dopées ($P^+$ et $N^+$).

De façon classique, pour obtenir un temps de recouvrement inverse faible qui caractérise une diode rapide, on crée des centres de recombinaison supplémentaires dans la région interne, généralement par dopage à l'or du silicium à haute résistivité. En effet, la charge stockée dans la jonction pendant la conduction directe s'évacue lors du changement de polarisation, et, pour une diode rapide, le courant inverse ne permettrait pas l'élimination de cette charge en un temps suffisamment bref. Le but du dopage à l'or est de réduire la charge initiale à évacuer. Il accentue le phénomène de recombinaison des paires électron-trou à l'endroit de la jonction en créant des centres de recombinaison supplémentaires dans le silicium pour "tuer" rapidement les porteurs minoritaires, c'est-à-dire de réduire considérablement leur durée de vie à des valeurs de l'ordre de quelques dizaines de ns. La charge stockée étant réduite par ce moyen, on voit que le temps de recouvrement est directement lié à la durée de vie.

Au contraire, dans un silicium à haute résistivité, non dopé à l'or, la durée de vie des porteurs minoritaires est de l'ordre de la ms. Dans la suite, on assimilera une telle durée de vie très longue à une durée "infinie", dans la mesure où le résultat théorique et pratique est le même que si la durée de vie était réellement infinie.

Le dopage à l'or, qui permet de diminuer le temps de recouvrement de la diode, présente cependant l'inconvénient d'accroître la tension de déchet (tension directe) de celle-ci très rapidement au fur et à mesure que la température de diffusion de l'or s'élève, ainsi que le courant inverse, qui passe d'une valeur de l'ordre des µA, pour un silicium intrinsèque non dopé, à une valeur de plusieurs mA.

Pour remédier à ces inconvénients inhérents au dopage à l'or, il a été proposé une structure de diode PIN telle que celle représentée aux figures 2 et 3: un substrat épais N, formant cathode, est recouvert d'une couche à haute résistivité d'épaisseur fonction de la tension inverse souhaitée, cette couche étant elle-même recouverte d'une mince couche superficielle de type P formant anode. Le très faible dopage de la zone à haute résistivité évite d'avoir un courant inverse élevé, mais la structure proposée ne

0148065

permet pas d'avoir à la fois un faible temps de recouvrement $t_{rr}$ et une tension inverse $V_R$ élevée, même en consentant un sacrifice important sur la tension de déchet (ces deux paramètres sont déterminés par les relations (interdépendantes) respectives :

$$t_{rr} = Q_S/I_T = \frac{W^2}{2\,D} \quad \text{et} \quad V_R = E_C \cdot W$$

avec $Q_S$ : charge stockée ; $I_T$ : courant inverse ; $W$ : largeur de la jonction ; $D$ : mobilité des porteurs ; $E_C$ : champ de claquage).

La figure 3 montre schématiquement la répartition des charges injectées (telles que représentées par la zone comprise entre la courbe de niveau de charge 6 et le niveau à l'équilibre thermique 7) ; dans une telle structure, cette répartition est dissymétrique. Il est donc nécessaire de faire un choix entre l'amélioration de l'un ou l'autre de ces deux paramètres, $t_{rr}$ ou $V_R$, mais pas les deux à la fois, même en admettant une tension de déchet plus importante, car $t_{rr}$ et $V_R$ sont liés par les relations précédentes selon :

$$t_{rr} = \frac{V_R^2}{2DE_C} \, .$$

En outre, dans une diode rapide classique, on constate généralement un accroissement de la charge stockée $Q_S$ – et corrélativement du temps de recouvrement – avec la température. Cette susceptibilité à la température peut être gênante dans certaines applications.

Au contraire, l'invention propose une structure assurant un compromis amélioré entre la tension de déchet, la tension inverse, le temps de recouvrement et le courant inverse, par rapport aux composants proposés jusqu'à présent, avec meilleure possibilité de libre choix des paramètres à favoriser.

Elle permet notamment la réalisation de composants haute tension rapides utilisables en commutation (diodes, redresseurs commandés), ayant des performances qu'il n'était jusqu'à présent pas possible d'atteindre par les structures de l'art antérieur. Moyennant certains amé-

nagements, il est également possible d'appliquer le même principe à des transistors bipolaires ou des MOS-bipolaires, ou encore des dispositifs du type SIT (c'est-à-dire des thyristors à induction statique).

Pour cela, l'une et l'autre des couches extérieures inférieure et supérieure sont, au moins dans une région active du composant, des couches minces ; la couche de silicium à haute résistivité est dépourvue de centres de recombinaison supplémentaires susceptibles de réduire la durée de vie des porteurs minoritaires présents dans cette couche au moment de la transition de l'état passant à l'état bloqué, l'épaisseur et le dopage des couches extérieures étant déterminés en fonction du degré d'injection souhaité desdits porteurs minoritaires dans la phase de conduction.

Par "couche mince", on entendra une couche d'épaisseur comprise entre quelques dizaines de nm et quelques µm, de préférence entre 0,2 et 1 µm environ.

Par ailleurs, en ce qui concerne la zone à haute résistivité , son épaisseur est déterminée en fonction de la tension inverse souhaitée.

En d'autres termes, l'invention propose une combinaison des deux caractéristiques structurelles suivantes :

. absence de dopage en centrestueurs de la zone interne, assurant un courant inverse minimal en conservant une durée de vie infinie aux porteurs minoritaires ;

. injection contrôlée des porteurs, par le choix de l'épaisseur et du dopage de l'une et de l'autre des couches extérieures de silicium extrinsèque ; cette injection contrôlée permet de n'injecter que la quantité nécessaire de porteurs, évitant ainsi d'avoir à "tuer" des porteurs qui se trouveraient en quantité excédentaire. Ceci permet également, en fonction de la valeur donnée à l'épaisseur et au dopage des couches extérieures, de choisir entre la minimisation de la tension de déchet et la minimisation du temps de recouvrement, en fonction des applications auxquelles sera destiné le composant.

En outre, un tel composant devrait montrer une plus faible susceptibilité à la température : la concentration $M_o$ des porteurs majoritaires et la profondeur $L_m$ de diffusion des porteurs minoritaires - qui sont les paramètres déterminant la charge stockée - sont en effet indépendantes de la température.

Le composant peut être une diode, la zone interne étant alors formée d'au moins une couche de silicium à haute résistivité, et les couches extérieures étant l'une du type N, l'autre du type P.

Le composant pourrait être également un redresseur commandé à gâchette P ou N, la couche extérieure adjacente à la gâchette étant alors du type N ou P, respectivement, la zone interne étant formée d'une couche de silicium à haute résistivité de type $\nu$ ou $\pi$, respectivement, juxtaposée à la couche formant gâchette, et la couche extérieure opposée à la gâchette étant du type P ou N respectivement.

Dans ce dernier cas, le contrôle de l'injection pourrait n'être éventuellement effectué que d'un seul côté du composant, c'est-à-dire qu'une seule des couches extérieures serait une couche mince au sens de l'invention.

Dans ces deux cas (diode et redresseur commandé), le composant présente, de préférence, une structure sensiblement symétrique des deux couches extérieures minces de part et d'autre de la zone interne, assurant un profil de charge plat dans cette zone interne, et par suite un meilleur compromis entre la tension inverse, le temps de recouvrement et la tension de déchet ; l'épaisseur de ces deux couches extérieures est alors avantageusement du même ordre de grandeur (si les électrons et les trous avaient la même mobilité,

· la structure pourrait être totalement symétrique).

Le composant pourrait être également un transistor NPN ou PNP comportant une couche P ou N, respectivement, formant base ; les couches extérieures sont alors du type $N^+$ ou $P^+$, respectivement, et la zone interne est formée d'une couche de silicium à haute résistivité de type $\nu$ ou $\pi$, respectivement, juxtaposée à la couche formant base.

Dans ce dernier cas, le contrôle de l'injection pourrait n'être éventuellement effectué que d'un seul côté du composant, c'est-à-dire qu'une seule des couches extérieures serait une couche mince au sens de l'invention.

En pratique, la fabrication d'un tel composant présente des difficultés importantes du fait de son épaisseur très faible.

En effet, dans le cas d'une diode par exemple, la zone à haute résistivité doit nécessairement être d'épaisseur réduite, de l'ordre de quelques dizaines de μm, déterminée seulement en fonction de la tension inverse souhaitée (par exemple 40 μm pour une tension de 800 V), et les couches extérieures sont des couches minces, c'est-à-dire de l'ordre du μm.

La réalisation et la manipulation de tranches de silicium aussi fines sont très difficiles sans risque de brisure. En outre, du point de vue électrique, cette faible épaisseur fait en sorte que la jonction est très proche de la surface du composant, entraînant une mauvaise tenue en tension de ce dernier en raison des effets parasites de bords, notamment lorsque l'on souhaite utiliser le composant en haute tension.

Pour remédier à cela, l'invention prévoit également que, sur une au moins des faces supérieure et inférieure, la couche extérieure soit mince dans une région centrale (vue en plan) et épaisse de part et d'autre de cette région, l'épaisseur de la région épaisse étant choisie de manière à assurer la tenue en tension aux bords du composant et à donner à celui-ci une robustesse d'ensemble suffisante pour permettre sa manipulation lors de la fabrication.

De préférence, la région épaisse s'étend (en plan) sur toute la périphérie du composant selon un profil fermé.

Dans le cas d'une diode, on a constaté, selon un aspect particulièrement avantageux de l'invention, que la région centrale et la région épaisse du composant forment respectivement une diode rapide et une diode lente, qui peuvent être mises en parallèle avec interposition, en série avec la diode lente, d'un élément résistif limitant le passage du courant dans cette dernière de façon à conserver les caractéristiques de rapidité du système ainsi obtenu.

De plus, la valeur de l'élément résistif peut être choisie de manière que le comportement oscillatoire du composant lors d'une transition de l'état passant à l'état bloqué soit voisin de l'amortissement critique, évitant ainsi bruit et surtension gênants.

Une façon de réaliser cette mise en parallèle est de prévoir une couche extérieure sans discontinuité entre la région centrale et la région épaisse, l'élément résistif étant alors formé par une zone de transition, d'épaisseur contrôlée, de la couche extérieure. Il est également possible de prévoir, au contraire, une discontinuité entre la région centrale et la région épaisse et de rapporter sur le composant l'élément résistif reliant ces deux régions.

D'autres caractéristiques et avantages de l'invention apparaîtront à la lecture de la description détaillée ci-dessous d'exemples de réalisation, en référence aux figures annexées sur lesquelles :

. la figure 1, précitée, montre la structure d'une diode PIN de la technique antérieure, avec dopage à l'or,

. les figures 2 et 3, précitées, se réfèrent à une diode asymétrique de la technique antérieure, avec son profil de charge associé,

. la figure 4 représente une diode réalisée selon les enseignements de l'invention,

. la figure 5 montre le profil de charge associé à la diode de la figure 4,

. la figure 6 se réfère au cas où le composant est un redresseur commandé à gâchette P, indiquant sa structure et son profil de charge,

. les figures 7 et 8 correspondent à deux variantes d'un transistor NPN réalisé suivant les enseignements de l'invention,

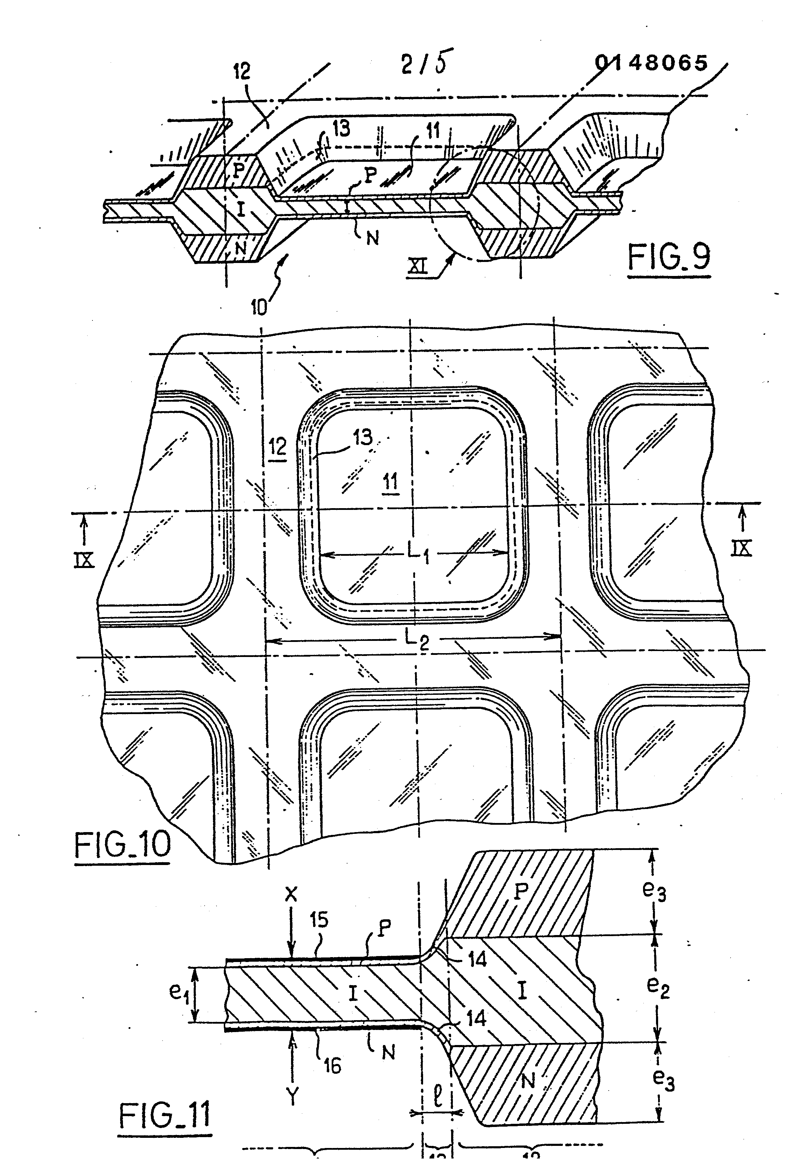

. la figure 9 est une coupe, selon la ligne IX-IX de la figure 10, d'une tranche de silicium dans laquelle ont été réalisées des diodes selon l'invention, avant séparation des composants unitaires,

. la figure 10 est une vue de dessus de la tranche de la figure 9,

. la figure 11 est un détail, correspondant au repère XI de la figure 9, montrant la zone de transition d'épaisseur contrôlée formant élément résistif,

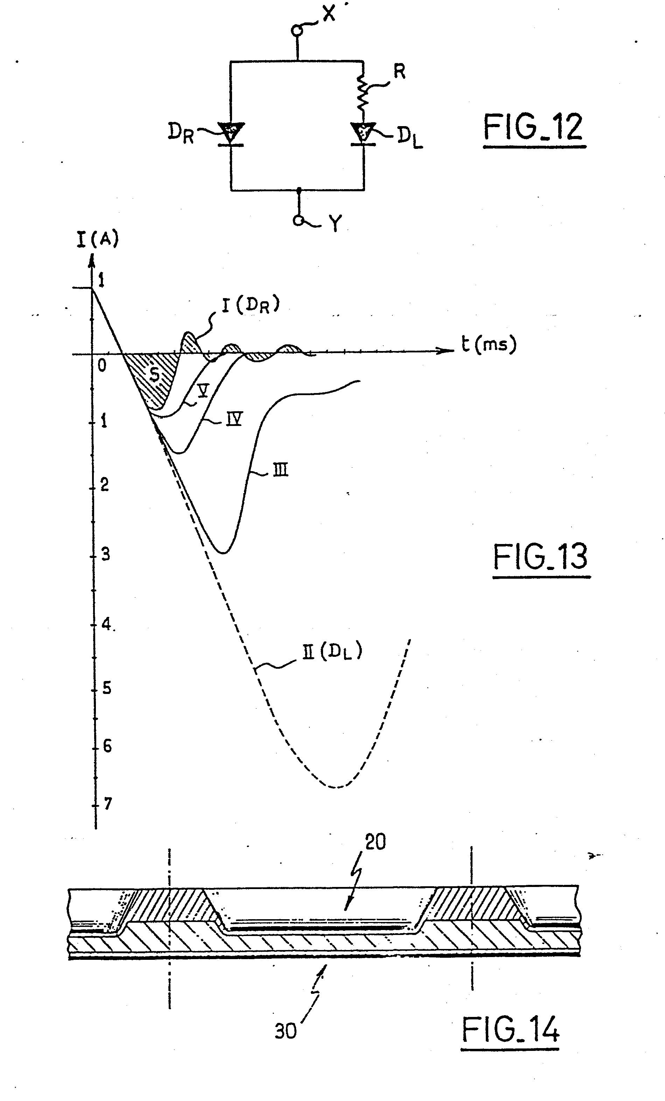

. la figure 12 est un schéma équivalent électrique de la diode PIN selon l'invention,

. la figure 13 montre la variation du courant inverse au moment de l'inversion de polarisation, pour différentes valeurs de l'élément résistif,

. la figure 14 est une variante correspondant à la figure 9, dans laquelle le creusement de la zone centrale est réalisé sur une seule des deux faces du composant,

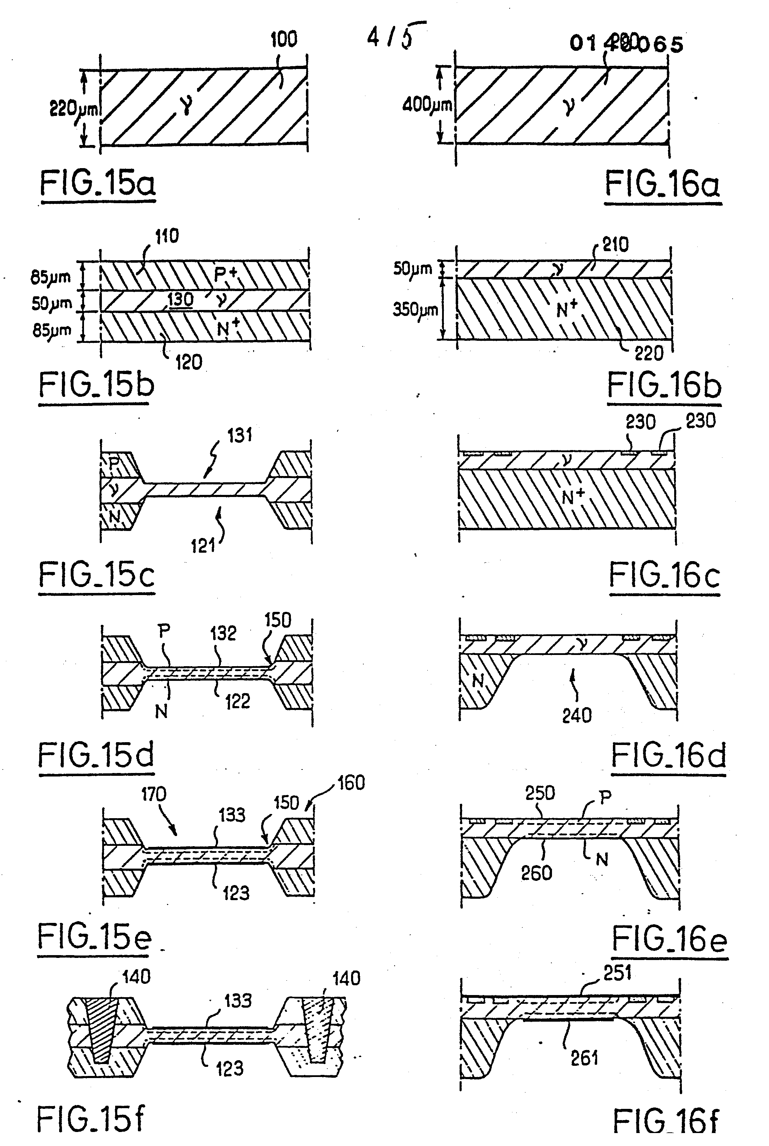

. les figures 15a à 15f illustrent les étapes d'un procédé de fabrication d'une diode selon l'invention, en technologie mesa et avec creusement symétrique,

. les figures 16a à 16f illustrent les étapes d'un procédé de fabrication d'une diode selon l'invention, en technologie planar et avec creusement sur une seule des faces du composant,

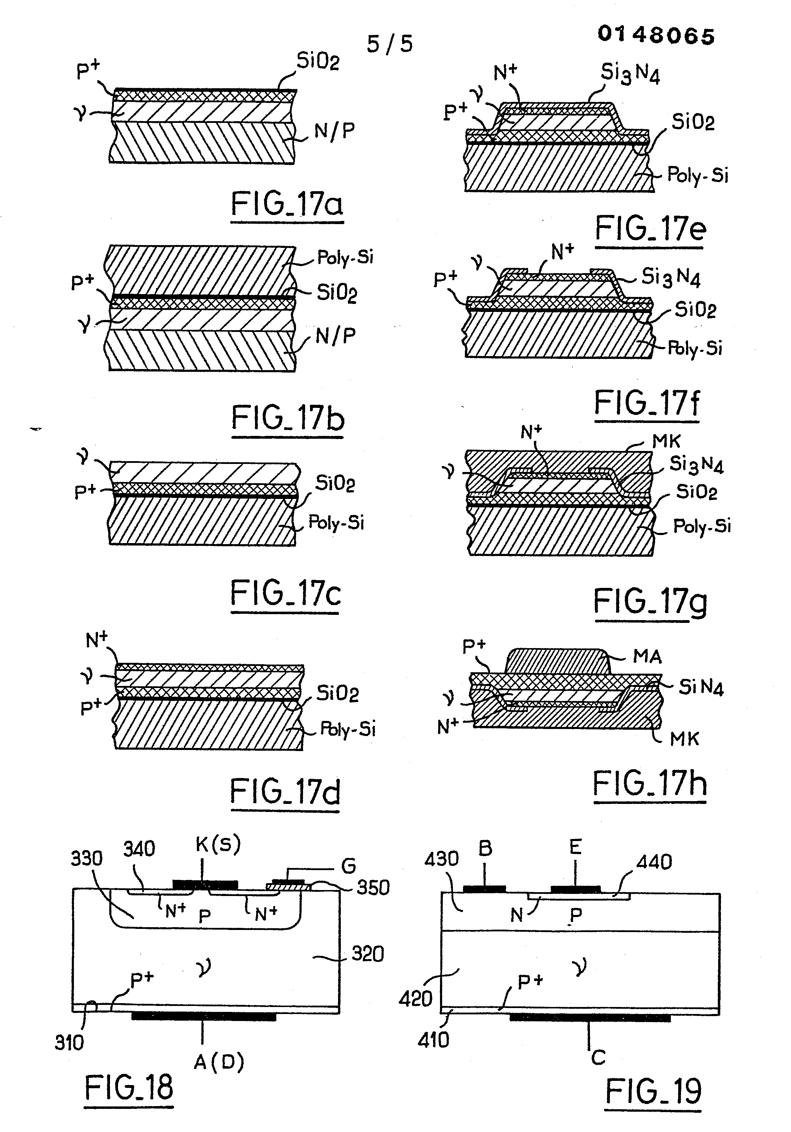

. les figures 17a à 17h illustrent les étapes d'un autre procédé de fabrication d'une diode selon l'invention en technologie mesa, permettant d'obtenir un composant dépourvu de zone périphérique de transition,

. la figure 18 montre la structure d'un transistor VMOS-bipolaire auquel on a appliqué les enseignements de l'invention, et

. la figure 19 montre une structure de type thyristor à laquelle on a appliqué les enseignements de l'invention.

Sur la figure 4 a été représentée schématiquement une diode réalisée suivant les enseignements de l'invention : une couche de silicium à haute résistivité I est entourée de deux couches minces P et N formant respectivement anode et cathode de la diode. L'épaisseur $e$ de la couche interne est déterminée en fonction de la tension inverse que devra supporter la diode, en fonction d'un gradient de tension de l'ordre de 15 à 20 V/µm. La couche supérieure P et la couche inférieure N sont toutes deux des couches minces (au sens défini plus haut), de manière à ne pas injecter plus de porteurs qu'il n'est nécessaire. (ici et dans la suite, on parlera de couches "supérieure" et "inférieure" pour la commodité de la description et en référence aux dessins, mais ces termes ne doivent suggérer aucune orientation particulière en ce qui concerne la structure ou la technologie de fabrication).

La zone interne est une zone de silicium à haute résistivité, c'est-à-dire très peu dopée, dont les porteurs minoritaires ont une durée de vie infinie.

Sur cette figure 4, la couche interne a été représentée sous forme d'une couche unique de silicium. Dans certaines applications, il peut cependant être avantageux de prévoir plusieurs couches successives formant la couche interne, par exemple une couche interne double formée de couches de silicium toutes deux à haute résistivité, mais de types π et ν respectivement.

On constate en effet dans le cas général que, au moment de la coupure du circuit, les charges stockées dans la jonction sont évacuées plus rapidement côté P que côté N. Une couche interne double (type ν côté N et type π côté P) permet précisément d'éviter les conséquences de cette évacuation dissymétrique en conservant dans la région interne un profil de charge aussi plat que possible jusqu'à la fin de l'évacuation des charges. L'apparition d'une zone déserte avant que toutes les charges n'aient été évacuées entraînerait en effet un ralentissement de la vitesse d'évacuation et un accroissement de la contretension subie.

A cet effet, les épaisseurs des couches π et ν sont sensiblement dans le même rapport que les vitesses d'évacuation des charges côté P et côté N, respectivement.

Une telle structure peut par exemple s'appliquer à la réalisation de diodes utilisées comme diodes de roue libre : dans cette configuration, les diodes sont en effet amenées à subir, au moment de la fermeture du circuit, un recouvrement sous pleine tension d'alimentation générale et sans limitation de courant. Le courant inverse dans la diode se transforme alors en courant de surcharge de fermeture pour le transistor de commande du circuit. La réduction de la charge stockée et son évacuation rapide permettent précisément d'éviter ces conséquences dommageables.

La résistivité de la zone interne est simplement celle qui convient à la tension inverse souhaitée, par exemple une résistivité de 25 $\Omega$.cm pour une tension de 800 V.

La courbe 7 de la figure 5 indique la répartition des charges dans la diode de la figure 4, depuis la cathode (à gauche) jusqu'à l'anode (à droite) : le contrôle de l'injection par le choix d'une faible épaisseur pour l'une et l'autre des régions d'extrémités N et P permet de conserver dans la région interne un profil de charge qui soit plat et symétrique, assurant une quantité de charges injectées dans la région interne relativement faible et dont l'élimination est par conséquent rapide à l'établissement de la tension inverse. Il en résulte ainsi, comme indiqué plus haut, un meilleur compromis entre tension inverse, temps de recouvrement et tension de déchet.

La figure 6 se réfère au cas où le composant est un redresseur commandé, par exemple un thyristor à gâchette P. La structure est identique à celle de la diode précédemment décrite, à la seule différente de la zone interne qui n'est plus composée d'une unique couche à haute résistivité, mais qui comprend deux couches : une couche à haute résistivité de type $\nu$ , et une couche de type P, formant gâchette. Le comportement d'un tel composant est, après basculement, tout à fait comparable à celui d'une diode PIN, et tout ce qui a été dit précédemment à propos de la diode peut trouver application ici. En particulier, on peut constater que le profil de charge dans la région interne (c'est-à-dire pour les deux couches $P_1$ et $\nu_2$) est un profil plat.

Par ailleurs, comme dans une diode, le contrôle de l'injection se fera par les deux couches d'extrémité, qui sont ici les couches désignées $N_1$ et $P_2$.

Cette structure est applicable à tout type de semiconducteur commandé, y compris les triacs et les semiconducteurs à ouverture par la gâchette. Dans ce dernier cas, le contrôle de l'injection peut en particulier conduire à une excellente maîtrise du comportement à l'ouverture, mieux que par les techniques classiques de dopage à l'or.

La figure 7 représente le cas d'un transistor réalisé selon les enseignements de l'invention. Dans ce cas, les deux couches supérieure et inférieure sont de type $N^+$, et constituent respectivement le collecteur et l'émetteur du composant. La zone interne est formée d'une couche de silicium à haute résistivité de type $\nu$, et d'une couche de silicium dopé P formant la base du transistor (ceci pour le cas d'un transistor NPN; pour un transistor PNP, il convient de prendre les types inverses).

Ici encore, le contrôle de l'injection se fait par les couches d'extrémités $N^+_e$ et $N^+_c$. On démontre cependant qu'il n'est pas nécessaire de contrôler l'injection par l'une et l'autre couches : en effet, si l'on recherche un gain maximal pour une tension de saturation et un temps de recouvrement faibles mais non minimaux il convient de ne contrôler l'injection que pour la couche $N^+_c$. Dans ce cas, la couche $N^+_e$ peut être relativement épaisse, comme représenté sur la figure 7. Il en résulte le profil de charge dissymétrique représenté sur cette figure.

Si au contraire on cherche à minimiser la tension de saturation et le temps de recouvrement au détriment du gain, l'injection peut être contrôlée pour les deux couches $N^+_e$ et $N^+_c$ ; on retrouve alors (figure 8) le profil de charge symétrique et plat précédemment rencontré.

En tout état de cause, la possibilité d'avoir une durée de vie infinie pour la zone centrale (couches $P_b$ et $\nu_c$) permet une modulation aussi homogène que possible de cette zone, avec un minimum de chute de tension interne.

La figure 9 représente une tranche de silicium dans laquelle a été réalisé un ensemble de diodes selon l'invention. La figure 9, ainsi que la figure 10 qui en est une vue de dessus, représentent la tranche de silicium avant découpe en composants individuels.

Le composant 10 comporte une région centrale 11 mince, entourée sur toute sa périphérie d'une région épaisse 12. La surépaisseur de la région 12 résulte pour l'essentiel d'une épaisseur plus grande donnée aux couches extérieures P et N. Cette surépaisseur peut également, mais non nécessairement, correspondre à une légère surépaisseur de la couche interne I. Comme il a été indiqué plus haut, la région épaisse périphérique 12 permet d'éviter les effets de bords à la périphérie de la jonction. Elle permet également une fabrication et une manipulation du composant sans risque de rupture. La région centrale a en effet une épaisseur de quelques dizaines de µm, ce qui la rend très fragile ; on peut par contre donner à la région périphérique une épaisseur de l'ordre de 200 à 400 µm, ce qui permet une manipulation du composant par les techniques classiques (notamment la découpe de la tranche de silicium, qui se fait par sillonnage de la zone épaisse).

Sur les figures, on a donné au composant une forme sensiblement carrée. Cette forme est utile dans le cas de fabrication de plusieurs composants juxtaposés dans une tranche, qui sont ensuite séparés par découpage. Mais elle n'est absolument pas limitative, ni même critique, et d'autres formes peuvent être envisagées en fonction des besoins particuliers.

La figure 11 montre le détail de la région de transition 13 entre la région mince 11 et la région épaisse 12. On peut voir que le léger élargissement de la couche interne de l'épaisseur $e_1$ à l'épaisseur $e_2$ permet d'obtenir dans la région de transition 13 une mince couche de silicium extrinsèque 14, qui formera élément résistif. Si la prise de contact se fait par des métallisations 15, 16 de la région centrale 11, on constate que, électriquement, le composant est équivalent au schéma électrique de la figure 12: la région centrale 11 constitue une diode rapide $D_R$ directement connectée entre les points de connexion X et Y du composant ; la région périphérique épaisse 12 constitue, quant à elle, une diode lente $D_L$, du fait de l'épaisseur importante (plusieurs dizaines de $\mu$m) des couches externes P et N qui ne permettent plus de contrôler l'injection des porteurs dans la zone centrale.

Cette diode lente $D_L$ constituée par la région périphérique n'est cependant pas connectée directement aux bornes X et Y du composant, mais par l'intermédiaire d'une résistance R constituée par les parties 14 de la région de transition 13.

En variante, on peut réaliser une couche extérieure non plus continue, mais discontinue entre la région centrale et la région périphérique, l'élément résistif étant alors un élément rapporté (non représenté), intégré ou non, reliant électriquement ces deux régions.

Le comportement du circuit de la figure 12 est décrit en référence à la figure 13. Cette figure est un graphique sur lequel on a porté l'intensité traversant le composant entre les bornes X et Y, en fonction du temps, l'instant t = 0 correspondant au passage de l'état passant (polarisation directe) à l'état bloqué (polarisation inverses).

La courbe I montre le comportement qu'aurait la diode rapide $D_R$ seule : ce comportement est un comportement oscillatoire amorti. De même, la courbe II montre l'allure du courant inverse pour une diode lente $D_L$ classique, seule.

En donnant à R des valeurs croissantes, on obtient le réseau de courbes III, IV, V, la courbe résultante se rapprochant d'autant plus de la courbe I que la valeur de R est élevée. De préférence, on donne à l'élément résistif du composant une valeur telle que le comportement d'ensemble du composant soit voisin de l'amortissement critique, ce qui correspond sensiblement à la courbe V.

On donne ainsi au composant selon l'invention une caractéristique qui est celle connue dans la technique sous le nom de diode à recouvrement progressif ("diode soft"). Il est en effet souvent souhaitable d'avoir un comportement non oscillatoire au moment des transitions, même si ce comportement est obtenu au prix d'une légère augmentation de la puissance dissipée (l'aire S étant en effet légèrement supérieure pour la diode obtenue que pour une diode rapide seule). Le choix d'un point de fonctionnement à l'amortissement critique permet d'éviter ce comportement oscillatoire, pour un minimum de dissipation de puissance.

Dans un exemple pratique de réalisation, on a réalisé une diode de forme sensiblement carrée avant une région centrale mince de côté L1 = 3000 µm et de dimension hors tout L2 = 3500 µm (figure 10). La couche à haute résistivité (figure 11) a une épaisseur $e_1$ = 60 µm dans la région centrale et $e_2$ = 80 µm dans la région périphérique. L'épaisseur $e_3$ de chacune des couches P et N dans la région périphérique a une valeur de 70 µm, ce qui donne au composant une épaisseur totale de 220 µm, compatible avec les techniques classiques de fabrication et de manipulation. La région de transition 13 a une largeur 1 d'au moins

50 µm, et l'on donne à chaque zone 14 une résistance de 2,5 Ω environ, soit une résistance série totale de 5 Ω environ.

Le composant ainsi réalisé présente les performances suivantes : tension inverse 1200 V ; courant direct 30 A ; tension de déchet 1,1 V ; temps de recouvrement 45 ns.

On notera que ce temps de recouvrement est environ 10 fois plus court que celui des diodes actuellement disponibles pour des tensions inverses de l'ordre de 1200 V. On a également proposé, pour obtenir des performances équivalentes en tension inverse et temps de recouvrement, de mettre en série un grand nombre de diodes rapides basse tension. Mais cette mise en série, outre la multiplication des composants individuels, se fait au détriment de la tension de déchet, multipliée par le nombre de diodes mises en série. Au contraire, la diode de l'invention permet de conserver une faible tension de déchet (de l'ordre du volt), qui ne varie, dans de faibles proportions, qu'en fonction de la tension inverse.

La figure 14 représente une variante de réalisation, dans laquelle la zone mince a été réalisée par creusement non plus des deux faces du composant, mais d'une seule face 20. Le choix de l'une ou de l'autre structure est sans influence sur les performances d'ensemble du composant ; il n'est fonction que de considérations technologiques. En particulier, le fait de disposer d'une face entièrement plane 30 permet un soudage direct du composant sur un substrat, cette face 30 étant alors entièrement métallisée, au contraire de la face 20, qui n'est métallisée sélectivement que dans la zone centrale.

Les figures 15a à 15f décrivent un procédé de fabrication d'une diode selon l'invention, par creusement symétrique des deux faces et emploi de la technologie mesa.

Au contraire, les figures 16a à 16f se réfèrent à un procédé planar avec creusement d'une seule des deux faces.

Cependant, ces choix technologiques ne sont donnés qu'à titre d'exemples illustratifs, et il est parfaitement possible de combiner les deux procédés décrits ou de mettre en oeuvre d'autres méthodes.

A cet égard, les figures 17a à 17h illustrent un autre procédé, permettant en particulier la réalisation de diodes dépourvues de zone périphérique de transition (zone référencée 13 sur les figures 9 à 11).

EXEMPLE 1 (figures 15a à 15f)

Figure 15a : On part d'une tranche homogène de silicium à haute résistivité de type $\nu$, ayant une épaisseur permettant sa manipulation par les techniques classiques, par exemple une épaisseur de 220 $\mu$m. La résistivité est choisie en fonction de la tension inverse souhaitée, par exemple une résistivité de 25 $\Omega$.cm pour une tension de service de 800 V.

Figure 15b : On procède à une double diffusion, de préférence symétrique, d'impuretés de manière à former deux zones 110 et 120 de types $P^+$ et $N^+$ d'épaisseur 85 $\mu$m entourant une zone interne 130 de silicium à haute résistivité restée intacte sur une épaisseur de 50 $\mu$m.

Figure 15c : On procède ensuite à une attaque sélective, par exemple une attaque chimique, de l'une et l'autre des zones dopées, de manière à former les régions centrales 121 et 131. L'attaque est réalisée à une profondeur légèrement supérieure à celle des zones diffusées. Le surplus de profondeur est aisé à ajuster, dans la mesure où le silicium à haute résistivité est beaucoup plus difficilement attaqué que les zones dopées.

Figure 15d : On dope ensuite les deux faces 122 et 132 de la région centrale sur une très faible profondeur, de manière à y créer des couches minces P et N. Ce dopage se fait de préférence par implantation ionique, ce qui permet un contrôle beaucoup plus précis du dopage que par diffusion. On se souviendra en effet que l'épaisseur et le dopage de ces couches extérieures déterminent le degré d'injection souhaité des porteurs minoritaires ; il est donc nécessaire de maîtriser parfaitement ces deux paramètres. La diffusion se fait également sur les bords de la zone centrale et la périphérie interne de la zone épaisse, en 150.

Figure 15e : Les deux faces du composant sont ensuite pourvues, sur la région centrale, de métallisations 122 et 123, limitées au centre de la plaquette, de façon à laisser subsister une zone résistive en 150, entre la diode mince 160 et la diode épaisse 170.

Figure 15f : La plaquette est ensuite découpée, de façon classique, par creusement de sillons 140 dans les régions épaisses. Enfin, des connexions seront rapportées sur les métallisations 123 et 133 pour permettre la prise de contact.

EXEMPLE II (Figures 16a à 16f)

Le procédé que l'on va décrire nécessite des tranches de silicium épitaxiées spéciales. Il a l'avantage de contrôler plus facilement le creusement des zones centrales et donne un composant moins fragile, dans la mesure où l'épaisseur de la tranche est plus élevée.

Figure 16a : On part d'une tranche homogène 200 de silicium intrinsèque de type $\nu$ , d'épaisseur 400 $\mu$m environ.

Figure 16b : On épitaxie sur cette tranche une couche 220 de type $N^+$, en laissant subsister une couche 210 de silicium à haute résistivité de 50 $\mu$m d'épaisseur environ (comme précédemment, l'épaisseur de la couche à haute résistivité est déterminée en fonction de la tension inverse que devra supporter le composant).

Figure 16c : On diffuse des anneaux de garde 230 à la surface de la couche à haute résistivité.

Figure 16d : On procède au creusement de la région centrale 240. Ce creusement peut par exemple être réalisé par creusement électrolytique, ce qui permet d'arrêter le creusement très exactement à l'interface des deux couches N et ν. Si l'on souhaite réaliser une zone de transition (correspondant à une résistance série),on pourra continuer à creuser sur une faible profondeur une fois l'interface atteint.

Figure 16e : On dope les zones 250 et 260, de préférence par implantation ionique, comme précédemment.

Figure 16f : On procède ensuite au dépôt des contacts : métallisation uniforme sur toute la face 251 de la tranche de silicium , sélective sur les régions centrales 261 de l'autre face.

La tranche est enfin découpée en composants individuels, chaque composant étant pourvu d'un fil de connexion permettant sa prise de contact, au moins sur la face 261 (un contact direct, sans connexion, est possible sur la face 251).

EXEMPLE III   (figures 17a à 17h)

Dans cet exemple, on réalise une diode dé-pourvue de zone périphérique de transition, n'ayant pas la forme en"assiette" décrite aux figures 9 à 11 : la difficulté consiste alors à supporter les différentes couches du composant pendant le processus de fabrication malgré la fragilisation d'ensemble de ces couches, qui ne comportent plus de région épaisse permettant une manipulation sans risque.

**Figure 17a** : on dépose une couche ν de silicium à haute résistivité ayant l'épaisseur définitive choisie pour le composant, sur un substrat épais référencé N/P : ce substrat, dont la résistivité est indifférente, est par exemple un substrat de type N, bien qu'un substrat de type opposé pourrait également convenir ; comme on le verra par la suite, le rôle de celui-ci est essentiellement mécanique, pour servir de semelle support aux couches relativement minces déposées à sa surface.

Sur la couche ν , on dépose une couche P+ ayant les caractéristiques (épaisseur, concentration) souhaitées pour le composant final ; cette dernière couche est recouverte d'une mince couche de protection de $SiO_2$.

On notera que, à la différence des procédés exposés précédemment, on donne dès l'abord à la couche P+ son épaisseur définitive ; on verra par la suite qu'il en sera de même pour la couche N+ formée par la suite.

Il est possible de réaliser des anneaux de garde pour la couche P+ dès cette étape du procédé.

**Figure 17b** : on dépose une couche épaisse de polysilicium au-dessus de la structure précédemment obtenue.

**Figure 17c** : l'ensemble est retourné, de sorte que c'est désormais la couche épaisse de polysilicium qui constitue la semelle, à la place du substrat N/P des étapes précédentes.

Ce substrat est d'ailleurs retiré entièrement, de manière à mettre à nu la couche ν de silicium à haute résistivité.

**Figure 17d** : sur cette couche ν , on forme (par diffusion ou implantation) la couche N+ qui constituera la cathode de la diode , avec son épaisseur définitive.

Figure 17e : on forme des "tables" (technologie MESA classique) qui délimitent les composants individuels à obtenir.

L'ensemble est recouvert d'une couche de nitrure de silicium permettant la passivation.

Figure 17f : on dégage le sommet de chacune des tables en pratiquant des ouvertures au travers de la couche de nitrure de silicium, de manière à mettre à nu la couche N+.

Figure 17g : l'ensemble est recouvert d'une métallisation de cathode MK venant en contact avec la couche N+ (et avec cette seule couche).

Cette métallisation a un triple rôle :
- prise de contact de cathode sur la couche N+
- radiateur intégré au composant
- et surtout, rôle de semelle support, pour venir en relais de la couche de polysilicium, qui sera retirée au cours de l'étape suivante ; le dépôt du métal est donc effectué (par exemple par électrolyse) sur une épaisseur suffisante pour assurer cette fonction mécanique de rigidification.

Figure 17h : le composant est retourné : c'est donc la couche de métallisation de cathode MK qui supporte la structure au cours de cette dernière étape de fabrication.

On élimine complètement la couche de polysilicium et la couche intermédiaire de protection de $SiO_2$, de manière à mettre à nu la couche P+ qui constituera l'anode du composant.

La prise de contact est effectuée par dépôt d'une métallisation d'anode MA, par exemple par croissance électrolytique.

Les étapes suivantes de découpe des composants individuels et de conditionnement sont des étapes classiques.


La figure 18 concerne un composant du type dit "MOS bipolaire" et auquel peuvent être appliqués les enseignements de l'invention.

De structure connue en elle-même, il comporte successivement un substrat (couche inférieure 310 sur la figure), de type P+, une couche 320 à haute résistivité de type ν, et une couche 330 de type P, à la surface de laquelle est diffusé un anneau 340 de conductivité N+. La couche inférieure 310 comporte une électrode d'anode/drain - la dénomination dépend du mode de fonctionnement envisagé - référencée A(D). Une électrode de cathode/source K(S) est en contact avec l'anneau 340, et une électrode de gâchette/grille G, isolée par le diélectrique 350, permet de polariser la couche P 330 (on notera que la seule différence de structure avec un VMOS de type classique réside dans le type de conductivité de la couche inférieure 310, qui est de type N pour un VMOS classique et de type P+ pour un VMOS bipolaire). Bien entendu, les différents types de conductivité peuvent être inversés pour l'ensemble des couches.

Lorsque ce composant fonctionne en mode thyristor (courant dépassant la valeur limite du courant de maintien), les deux couches N+ (côté source) et P+ (côté drain) sont, selon l'invention, des couches minces à injection contrôlée des porteurs. Les avantages sont ceux explicités à propos du thyristor classique (choix du meilleur compromis entre chute de tension en direct et charge stockée), avec en outre la possibilité de commande à haute impédance de type MOS et le di/dt élevé, propres au VMOS bipolaire.

Dans l'autre mode de fonctionnement - mode VMOS à résistance série améliorée -, c'est-à-dire pour un courant inférieur au courant de maintien, la caractéristique de l'invention (couche mince à injection contrôlée) peut être appliquée soit aux deux couches N+ et P+, comme précédemment, soit à la seule couche P+ qui est celle jouant un rôle déterminant dans ce mode.

On sait en effet que le VMOS bipolaire travaillant dans ce mode présenterait une chute de tension en direct élevée (préjudiciable notamment pour un composant haute tension), sans l'injection de porteurs minoritaires depuis la couche P+ : en modulant ainsi la zone $\nu$ , on réduit sa résistance au passage du courant direct. Ce gain sur la chute de tension en direct s'accompagne cependant d'une perte en rapidité corrélative.

Le contrôle précis de cette injection, en appliquant les enseignements de l'invention à cette couche P+ - et a fortiori en les appliquant aux deux couches extérieures P+ et N+ - permet de s'affranchir de cet inconvénient, grâce à la réduction de la charge stockée à une valeur minimale.

La figure 19 concerne un composant de type thyristor. La commande y est réalisée par un courant de base et non par une tension de grille, comme dans le MOS bipolaire.

Il comprend une couche inférieure 410 de type P+, auquel est reliée une électrode C de collecteur, une couche centrale 420 à haute résistivité de type $\nu$ , une couche 430 de type P reliée à une électrode B de base, et une couche supérieure 440, de type N, reliée à une électrode E d'émetteur (bien entendu, les types de conductivité peuvent être inversés pour l'ensemble des couches).

A la différence du VMOS bipolaire, il devient possible, au moment de l'ouverture, d'extraire par la base B les charges stockées (ce qui était impossible par la grille isolée G du VMOS bipolaire, dans lequel les charges doivent disparaître sur place). Ceci permet d'obtenir un composant particulièrement rapide.

Comme précédemment, c'est essentiellement la couche P+ 410 qui est une couche mince à injection contrôlée des porteurs minoritaires. Le cas échéant, cette caractéristique peut être prévue pour les deux couches extérieures P+ 410 et N 440, comme représenté sur la figure.

25

0148065

REVENDICATIONS

1. Un composant semiconducteur haute tension rapide, comprenant une zone interne, formée d'au moins une couche de silicium à haute résistivité, comprise entre deux couches extérieures supérieure et inférieure de silicium extrinsèque, caractérisé en ce que l'une et l'autre des couches extérieures inférieure et supérieure sont, au moins dans une région active du composant, des couches minces et en ce que la couche de silicium à haute résistivité est dépourvue de centres de recombinaison supplémentaires susceptibles de réduire la durée de vie des porteurs minoritaires présents dans cette couche au moment de la transition de l'état passant à l'état bloqué, l'épaisseur et le dopage des couches extérieures étant déterminés en fonction du degré d'injection souhaité desdits porteurs minoritaires dans la phase de conduction.

2. Un composant selon la revendication 1, caractérisé en ce que l'épaisseur des couches extérieures est du même ordre de grandeur pour l'une et l'autre couche.

3. Un composant semiconducteur selon la revendication 1, caractérisé en ce que le composant est une diode, la zone interne étant formée d'au moins une couche de silicium à haute résistivité, et les couches extérieures étant l'une du type N, l'autre du type P.

4. Un composant semiconducteur selon la revendication 1, caractérisé en ce que le composant est un redresseur commandé à gâchette P ou N, la couche extérieure adjacente à la gâchette étant du type N ou P respectivement, la zone interne étant formée d'une couche de silicium à haute résistivité de type $\nu$ ou $\pi$, respectivement, juxtaposée à la couche formant gâchette, et la couche extérieure opposée à la gâchette étant du type P ou N, respectivement.

5. Un composant semiconducteur selon la revendication 1, caractérisé en ce que le composant est un transistor NPN ou PNP comportant une couche P ou N, respectivement, formant base, les couches extérieures étant du type $N^+$ ou $P^+$, respectivement, la zone interne étant formée d'une couche de silicium à haute résistivité de type $\nu$ ou $\pi$, respectivement, juxtaposée à la couche formant base.

6. Un composant semiconducteur selon la revendication 1, caractérisé en ce que sur l'une au moins des faces supérieure et inférieure, là couche extérieure est mince dans une région centrale (11), vue en plan, et épaisse de part et d'autre de cette région, l'épaisseur de la région épaisse (12) étant choisie de manière à assurer la tenue en tension aux bords du composant et à donner à celui-ci une robustesse d'ensemble suffisante pour permettre sa manipulation lors de la fabrication.

7. Un composant selon la revendication 6, caractérisé en ce que la région épaisse s'étend en plan, sur toute la périphérie du composant selon un profil fermé.

8. Un composant semiconducteur selon la revendication 6, dans lequel la région centrale et la région épaisse forment respectivement une diode rapide ($D_R$) et une diode lente ($D_L$), caractérisé en ce que ces deux diodes sont mises en parallèle avec interposition, en série avec la diode lente, d'un élément résistif (R) de limitation du courant dans la diode lente, la prise de contact étant effectuée sur les couches minces de la région centrale.

9. Un composant semiconducteur selon la revendication 8, caractérisé en ce que la valeur de l'élément résistif est choisie de manière que le comportement oscillatoire du composant lors d'une transition de l'état passant à l'état bloqué soit voisin de l'amortissement critique.

10. Un composant semiconducteur selon la revendication 8, caractérisé en ce que la couche extérieure est réalisée sans discontinuité entre la région centrale et la région épaisse, l'élément résistif étant alors formé par une zone de transition (14), d'épaisseur contrôlée, de la couche extérieure.

11. Un composant semiconducteur selon la revendication 8, caractérisé en ce que la couche extérieure est réalisée avec discontinuité entre la région centrale et la région épaisse, l'élément résistif étant alors un élément rapporté reliant électriquement ces deux régions.

12. Un composant semiconducteur haute tension rapide du type semiconducteur commandé, comprenant une zone interne, formée d'une couche de silicium à haute résistivité de type $\nu$ ou $\pi$ , respectivement, juxtaposée à une couche de type P ou N, respectivement, reliée à l'électrode de commande, comprise entre deux couches extérieures supérieure et inférieure de silicium extrinsèque, la couche extérieure adjacente à la couche reliée à l'électrode de commande étant du type N ou P respectivement, et la couche extérieure opposée à la couche reliée à l'électrode de commande étant du type P ou N, respectivement, caractérisé en ce que l'une au moins des couches extérieures inférieure et supérieure est, au moins dans une région active du composant, une couche mince, et en ce que la couche de silicium à haute résistivité est dépourvue de centres de recombinaison supplémentaires susceptibles de réduire la durée de vie des porteurs minoritaires présents dans cette couche au moment de la transition de l'état passant à l'état bloqué, l'épaisseur et le dopage des couches extérieures étant déterminée en fonction du degré d'injection souhaité desdits porteurs minoritaires dans la phase de conduction.

13. Un composant semiconducteur selon la revendication 12, caractérisé en ce que l'électrode de commande est une grille isolée commandée en tension.

14. Un composant semiconducteur selon la revendication 12, caractérisé en ce que l'électrode de commande est une électrode de commande en courant.

15. Un composant semiconducteur selon la revendication 12, du type transistor NPN ou PNP comportant une couche P ou N, respectivement, formant base comprenant une zone interne formée d'une couche de silicium à haute résistivité de type $\nu$ ou $\pi$ , respectivement, juxtaposée à la couche formant base, et comprise entre deux couches extérieures supérieure et inférieure de silicium extrinsèque, les couches extérieures étant du type N+ ou P+, respectivement, caractérisé en ce que l'une au moins des couches extérieures inférieure et supérieure est, au moins dans une région active du composant, une couche mince, et en ce que la couche de silicium à haute résistivité est dépourvue de centres de recombinaison supplémentaires susceptibles de réduire la durée de vie des porteurs minoritaires présents dans cette couche au moment de la transition de l'état passant à l'état bloqué, l'épaisseur et le dopage des couches extérieures étant déterminée en fonction du degré d'injection souhaité desdits porteurs minoritaires dans la phase de conduction.

16. Un composant semiconducteur selon l'une des revendications 12 à 15, caractérisé en ce que sur l'une au moins des faces supérieure et inférieure, la couche extérieure est mince dans une région centrale (11), vue en plan, et épaisse de part et d'autre de cette région, l'épaisseur de la région épaisse (12) étant choisie de manière à assurer la tenue en tension aux bords du composant et à donner à celui-ci une robustesse d'ensemble suffisante pour permettre sa manipulation lors de la fabrication.

FIG.1

FIG.2

FIG.3

FIG.4

FIG.5

FIG.6

FIG.7

FIG.8

FIG.9

FIG.10

FIG.11

X

R

$D_R$      $D_L$

Y

FIG_12

I(A)

1

I($D_R$)

S

t(ms)

0

V

IV

1

III

2

3

II($D_L$)

4

5

6

7

FIG_13

20

30

FIG_14

100

220μm    γ

## FIG.15a

400μm    γ

## FIG.16a

110

85μm    P+

50μm    130    γ

85μm    N+

120

## FIG.15b

210

50μm    γ

350μm    N+

220

## FIG.16b

131

P
γ
N

121

## FIG.15c

230    230

γ

N+

## FIG.16c

P    132    150

122
N

## FIG.15d

γ

N

240

## FIG.16d

170    150    160

133

123

## FIG.15e

250    P

260    N

## FIG.16e

140    140

133

123

## FIG.15f

251

261

## FIG.16f

5 / 5

0148065

FIG_17a

FIG_17b

FIG_17c

FIG_17d

FIG_17e

FIG_17f

FIG_17g

FIG_17h

FIG_18

FIG_19